(19) Europäisches Patentamt
European Patent Office
Office européen des brevets

(11) EP 2 986 669 B1

(12) # FASCICULE DE BREVET EUROPEEN

(45) Date de publication et mention de la délivrance du brevet:
**04.10.2017 Bulletin 2017/40**

(21) Numéro de dépôt: **14721801.0**

(22) Date de dépôt: **18.04.2014**

(51) Int Cl.:
***C08K 5/098*** *(2006.01)* ***C08F 214/22*** *(2006.01)*
***H01L 41/193*** *(2006.01)*

(86) Numéro de dépôt international:
**PCT/EP2014/057997**

(87) Numéro de publication internationale:
**WO 2014/170479 (23.10.2014 Gazette 2014/43)**

(54) **PROCÉDÉ DE FABRICATION DE MATÉRIAU COMPOSITE POLARISABLE SOUS L'ACTION D'UN FAIBLE CHAMP ÉLECTRIQUE**

VERFAHREN ZUR HERSTELLUNG EINES UNTER DER WIRKUNG EINES SCHWACHEN ELEKTRISCHEN FELDES POLARISIERBAREN VERBUNDWERKSTOFFS

METHOD FOR MANUFACTURING COMPOSITE MATERIAL WHICH IS POLARIZABLE UNDER THE ACTION OF A WEAK ELECTRIC FIELD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.04.2013 FR 1353537**

(43) Date de publication de la demande:
**24.02.2016 Bulletin 2016/08**

(73) Titulaire: **Institut National des Sciences Appliquées de Lyon**
**69100 Villeurbanne (FR)**

(72) Inventeurs:
- **CAPSAL, Jean-Fabien**
  **F-69200 Venissieux (FR)**
- **GALINEAU, Jerémy**
  **F-69100 Villeurbanne (FR)**
- **COTTINET, Pierre-Jean**
  **F-69400 Limas (FR)**
- **LALLART, Mickaël**
  **69100 Villeurbanne (FR)**
- **GUYOMAR, Daniel**
  **F-69100 Villeurbanne (FR)**

(74) Mandataire: **Be IP**
**Cabinet LTL SAS**
**Centre d'Entreprise et d'Innovation**
**56, Bd Niels Bohr**
**CS 52132**
**69603 Villeurbanne Cedex (FR)**

(56) Documents cités:
**EP-A1- 1 748 053**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 986 669 B1

Printed by Jouve, 75001 PARIS (FR)

## Description

### DOMAINE TECHNIQUE

La présente invention concerne le domaine technique des matériaux composites polarisables sous l'action d'un champ électrique, et plus particulièrement, des matériaux composites comprenant un polymère organique ferroélectrique présentant un caractère relaxeur.

Le caractère relaxeur d'un polymère implique :

- que la barrière de transformation entre les phases polaires et non polaires de celui-ci soit diffuse et
- qu'à température ambiante un changement réversible entre ces phases puisse être induit sous l'action d'un champ électrique, avec très peu d'hystérésis.

Les polymères organiques ferroélectriques présentant un caractère relaxeur doivent posséder également une bonne élasticité mécanique permettant une déformation importante sous l'action d'un champ électrique.

### ETAT DE LA TECHNIQUE

On connaît des polymères organiques ferroélectriques présentant un caractère relaxeur, tels que des terpolymères comprenant :

- un premier monomère de fluorure de vinylidène (ou *« VDF »,* sigle de l'expression anglo-saxonne « *vinylidene fluoride* »), associé à
- un deuxième monomère choisi parmi le trifluoroéthylène (ou « *TrFE* », sigle de l'expression anglo-saxonne « *trifluoroethylene »*) ou le tétrafluoroéthylène, (ou « *TFE* », sigle de l'expression anglo-saxonne « *tetrafluoroethylene »*)*,* associé à
- un troisième monomère choisi parmi le chlorofluoro-1,1,éthylène (ou « *CFE »,* sigle de l'expression anglo-saxonne « *chlorofluoroethylene »*) ou le chlorotrifluoroéthylène (ou « *CTFE* », sigle de l'expression anglo-saxonne *« chlorotrifluoro ethylene »*).

Le niveau élevé des champs électriques à appliquer à ces polymères constitue un obstacle majeur pour développer de nombreuses applications, notamment pour la fabrication d'actionneurs.

En effet, les tensions électriques nécessaires à ces applications doivent être faibles, en particulier dans les domaines biologique, électronique, robotique, haptique, etc. pour une utilisation correcte, efficace et sans danger.

Pour réduire cette exigence de champ électrique élevé, des solutions de matériaux composites ont été proposées. Elles consistent en un mélange du terpolymère et d'un matériau conducteur, notamment pour augmenter la constante diélectrique du matériau composite incluant le terpolymère.

Toutefois, les rigidités diélectriques de tels matériaux composites sont faibles, et l'influence des particules conductrices sur les propriétés électromécaniques limitée. Enfin, la fabrication de tels matériaux composites est coûteuse et peu reproductibles sur le plan industriel.

L'un des buts de la présente invention est de pallier au moins l'un des inconvénients des matériaux et procédés de fabrication précités.

Notamment, un but de la présente invention est de proposer un matériau composite :

- présentant une induction électrique équivalente à celle du matériau pur mais sous un champ électrique moins élevé,
- présentant une déformation électromécanique équivalente à celle du matériau pur mais sous un champ électrique moins élevé,
- présentant une rigidité diélectrique supérieure à celle des matériaux composites incluant un mélange de terpolymère et de matériau conducteur,
- présentant un couplage électromécanique équivalent à celui du matériau pur mais sous un champ électrique moins élevé.

Un autre but de la présente invention est de proposer un procédé de fabrication du matériau composite qui soit fiable, peu coûteux et reproductible.

### RESUME DE L'INVENTION

A cet effet l'invention concerne un matériau composite comprenant :

- au moins un polymère organiques ferroélectrique relaxeur, le polymère organique ferroélectrique relaxeur étant un terpolymère à base de :

  ◦ difluorure de vinylidène (VDF), de
  ◦ trifluoroéthylène (TrFE), et de
  ◦ chlorofluoro 1, 1 éthylène (CFE) ou de chlorotrifluoroéthylène (CTFE), et

- au moins un matériau plastifiant à base de phtalates.

On entend, dans le cadre de la présente invention, par « *polymère organique ferroélectrique relaxeur »,* un polymère présentant une constante diélectrique au moins égale à 30 à température ambiante, la constante diélectrique variant sous champ électrique et en fréquence, par exemple variant de 50% sous champ électrique de 80 V/μm à une fréquence de 0.1 Hz. Ce polymère est caractérisé par un changement de conformation moléculaire réversible de la phase cristalline.

En mélangeant le polymère organique ferroélectrique relaxeur en phase polaire à un matériau plastifiant à base de phtalates peu polaire qui interagit avec la phase polaire du polymère pur, les valeurs des champs nécessaires à l'actionnement du nouveau composite sont diminuées en comparaison du matériau pur. La permittivité diélectrique du matériau composite obtenu est grandement augmentée.

Le document US 2010/0148632 décrit l'utilisation de plastifiant dans un polymère pour augmenter l'électro-activité de la composition ainsi obtenue.

Le polymère peut être du fluorure de polyvinylidène, de la polyépichlorhydrine, de la polysaccharide ou un mélange de ces composés (en particulier de l'amylose, de l'amylopectine, de la cellulose), de l'alcool polyvinylique, du poly(chlorure de vinyle), du polysulfone, du Polycarbonate, du polyester (en particulier du poly(éthylène téréphtalate)), de la protéine (comme la caséine), du polyacrylonitrile, de l'oxyde de polyalkyle (en particulier un oxyde de polyéthylène), du polyamide, du poly(hexaméthylène-adipamide), de l'uréthane aromatique, de d'uréthanne acrylate aromatique, de l'acrylate d'alkyle, du polyvinylpyrrolidone, du polyethyloxazoline, et des copolymères et mélanges de ces polymères.

De même, le plastifiant peut être de un alcool mono ou polyfonctionnel, un anhydride, un aldéhyde ou une cétone, un plastifiant à base de sulfure, un amide d'acide carboxylique, un nitrile organique, une amine, un acide cyanocarboxylique, un composé aromatique incluant un groupe nitrile, un carbonate, etc.

Ainsi, US 2010/0148632 enseigne à l'homme du métier que le mélange de n'importe quel plastifiant avec n'importe quel polymère permet d'augmenter l'électro-activité de la composition ainsi obtenue.

Selon US 201/0148632, ceci est dû à une augmentation de la mobilité des chaînes dans le polymère grâce à l'ajout de plastifiant.

En référence à l'exemple 3 de US 2010/0148632, on constate qu'en ajoutant un plastifiant de type dibutylephtalate dans un polymère de type poly(chlorure de vinyle), la permittivité diélectrique relative effective augmente d'un facteur 2 par rapport au polymère pur.

Dans le cadre de la présente invention, la sélection :

- d'un type de polymère particulier - à savoir un polymère ferroélectrique ayant un comportement relaxeur - et
- d'un type de plastifiant particulier - à savoir un plastifiant à base de phtalates permet d'augmenter la permittivité diélectrique relative effective d'un facteur 16.

En effet, c'est notamment le caractère relaxeur du polymère qui permet d'obtenir de tels résultats. L'importance du caractère relaxeur du polymère n'est ni décrit ni enseigné dans US 2010/0148632.

Des aspects préférés mais non limitatifs du matériau composite selon l'invention sont les suivants :

- le polymère organique ferroélectrique relaxeur est un polymère de permittivité relative supérieure à 40 pour une fréquence de 100 mHz et une température de 25°C ;
- le matériau plastifiant à base de phtalates est le Phtalate de bis(2-éthylhexyle) (DEHP) ;
- le matériau plastifiant à base de phtalates représente de 5 à 30 % en masse par rapport à la masse totale du matériau composite ;
- le polymère organique ferroélectrique relaxeur représente de 70 à 95 % en masse par rapport à la masse totale du matériau composite ;
- l'état d'induction électrique est d'au moins 50 $mC/m^2$ sous un champ électrique de 20V/μm.

L'invention concerne également un procédé de fabrication d'un matériau composite comprenant :

- une étape de mélange (10) d'au moins un polymère organique ferroélectrique relaxeur et d'au moins un matériau plastifiant à base de phtalates pour obtenir un mélange, le polymère organique ferroélectrigue relaxeur étant un terpolymère à base de :

◦ difluorure de vinylidène (VDF), de
◦ trifluoroéthylène (TrFE), et de
◦ chlorofluoro 1, 1 éthylène (CFE) ou de chlorotrifluoroéthylène (CTFE), et

- une étape de traitement (20) du mélange pour obtenir le matériau composite, ladite étape de traitement incluant une sous-étape consistant à réaliser un film à partir du mélange et une sous-étape consistant à sécher et recuire ledit film.

Des aspects préférés mais non limitatifs du procédé de fabrication selon l'invention sont les suivants :

- l'étape de mélange est réalisée par voie solvant et comprend les sous-étapes consistant à :

◦ solubiliser le polymère organique ferroélectrique relaxeur et le matériau plastifiant à base de phtalates dans au moins un solvant commun au polymère organique ferroélectrique relaxeur plastifiant et au matériau plastifiant à base de phtalates,
◦ éliminer ledit et au moins un solvant ;

- l'étape de mélange est réalisée par voie fondue ; la sous-étape de recuit consiste en un chauffage :

◦ à une température inférieure à la température de fusion du mélange, et
◦ pendant une durée supérieure ou égale à une minute ;

- le procédé comprend en outre une étape consistant au dépôt d'électrodes sur le matériau composite.

L'invention concerne également un élément actionneur remarquable en ce qu'il comprend une pièce incluant le matériau composite tel que décrit ci-dessus, et au moins deux électrodes liées à ladite pièce et mutuellement isolées, lequel élément actionneur peut être incurvé et déformé par application d'une différence de potentiel électrique entre les deux électrodes.

## BREVE DESCRIPTION DES FIGURES

D'autres caractéristiques, buts et avantages de la présente invention ressortiront encore de la description qui suit, laquelle est purement illustrative et non limitative et doit être lue au regard des dessins annexés sur lesquels :

- La figure 1 illustre un exemple de structure composite incluant un matériau composite,
- La figure 2 illustre un exemple de procédé de fabrication d'un matériau composite,
- Les figures 3 à 6 sont des courbes illustrant le comportement d'un terpolymère pur et d'un matériau composite composé du terpolymère pur mélangé à 15% en masse de Phtalate de bis(2-éthylhexyle) par rapport à la masse totale du matériau composite.

## DESCRIPTION DETAILLEE

On va maintenant décrire plus en détails le matériau composite et son procédé de fabrication associé en référence aux figures 1 et 2.

En référence à la figure 1, une structure composite est illustrée. Cette structure comprend une couche de matériau composite 13 intercalée entre deux couches électriquement conductrices 11, 12 formant les électrodes.

La couche de matériau composite 13 comprend un mélange d'un (ou plusieurs) polymère(s) organique(s) ferroélectrique(s) à comportement relaxeur, et d'un (ou plusieurs) matériau(x) plastifiant à base de phtalates.

Le polymère est par exemple un terpolymère P(VDF-TrFE-CFE) ou un terpolymère P(VDF-TrFE-CTFE).

Le matériau plastifiant est par exemple du Phtalate de bis(2-éthylhexyle) (ou *« DEHP »*, sigle de l'expression anglo-saxonne « *DiEthylHexyl Phthalate* »).

Le fait de mélanger un terpolymère en phase polaire - tel qu'un terpolymère P(VDF-TrFE-CFE) ou un terpolymère P(VDF-TrFE-CTFE) - avec un autre matériau peu polaire - tel qu'un matériau plastifiant à base de phtalates - qui interagit avec la phase polaire du terpolymère permet d'augmenter la permittivité diélectrique du matériau composite obtenu.

Les inventeurs ont en effet découvert que le mélange d'un polymère du type organique ferroélectrique à comportement relaxeur, avec un matériau plastifiant à base de phtalates augmente la permittivité diélectrique du matériau composite obtenu, et donc, par exemple pour un terpolymère à base de VDF de TrFE et de CFE (ou de CTFE) avec un mélange terpolymère/agent plastifiant 85/15 en % massique :

- d'atteindre un état d'induction électrique d'au moins 75 $mC/m^2$ sous un champ électrique de 20 V/$\mu$m, soit une tension 10 fois moins élevée que pour le terpolymère pur à base de VDF de TrFE et de CFE (ou de CTFE),
- de passer d'une permittivité relative d'environ 50 pour le terpolymère pur à base de VDF de TrFE et de CFE (ou de CTFE), à une permittivité relative d'environ 725 dans le cas du matériau composite,
- d'augmenter la réponse électromécanique d'un facteur 28 (et donc de diminuer le champ nécessaire ou d'augmenter la déformation à champ constant) et la densité d'énergie mécanique associée d'un rapport 215 par rapport au terpolymère pur à base de VDF de TrFE et de CFE (ou de CTFE).

De préférence, le matériau plastifiant à base de phtalates représente de 5 à 30 % en masse par rapport à la masse totale du matériau composite 13, et le polymère organique ferroélectrique relaxeur représente de 70 à 95 % en masse par rapport à la masse totale du matériau composite 13. Ceci permet une augmentation du volume libre des chaînes de polymères tout en garantissant une bonne tenue mécanique du matériau composite.

En référence à la figure 2, le procédé de fabrication comprend :

i) une étape de mélange 10 en voie solvant ou en voie fondue :

  - ◦ d'un terpolymère à base de monomères de VDF (difluorure de vinylidène) de TrFE (trifluoroéthylène) et de CFE (chlorofluoro 1,1, éthylène) ou de CTFE (chlorotrifluoroéthylène) avec,
  - ◦ un plastifiant liquide de la famille des phtalates (DEHP par exemple).

ii) une étape de traitement 20 du mélange dans laquelle :

  - ◦ un film est réalisé à partir du mélange par des techniques classiques telles que des techniques de coulée en voie solvant ou fondue,
  - ◦ le film est séché et recuit de façon appropriée pour le cristalliser; notamment le recuit peut consister en un chauffage :
    - ▪ à une température inférieure à la température de fusion du mélange, et
    - ▪ pendant une durée supérieure ou égale à une minute,
  - ◦ des électrodes sont apposées sur le film (étape 30).

Le procédé de fabrication décrit ci-dessus permet d'obtenir des polymères présentant une induction électrique équivalente au matériau pur, mais obtenue sous des champs électriques plus faibles.

Dans un exemple d'application préférée du procédé selon l'invention, le terpolymère P(VDF-TrFE-CFE) (ou le terpolymère P(VDF-TrFE-CTFE)) est mélangé avec « *a* » % de DEHP.

Le terpolymère P(VDF-TrFE-CFE) (ou le terpolymère P(VDF-TrFE-CTFE)) mélangé avec « a » % de DEHP est composé de « *x* » % en moles de VDF, de « *y* » % en moles de TrFE et de « *100-x-y* » % en moles de CFE (ou de CTFE), où « *x* » est compris entre 20 et 40 et où la somme de « *x* » et « *y* » est comprise entre 90 et 97. La valeur de « *a* » est comprise entre 1 et 30%.

A titre d'exemple, le terpolymère P(VDF-TrFE-CFE) mélangé avec le DEHP est composé de :

- 61.8% en moles de VDF,
- 29.8% en moles de TrFE et
- 8.5% en moles de CFE.

On va maintenant présenter plus en détails une étude réalisée par les inventeurs et permettant de mieux comprendre les avantages de l'invention.

*Théorie relative à l'invention*

Pour présenter les avantages associés à la présente invention, le terpolymère P(VDF-TrFE-CFE) a été utilisé. Ce matériau a suscité un intérêt croissant ces dernières années en raison de son comportement ferroélectrique relaxeur, sa forte permittivité diélectrique ($\varepsilon_r \sim 50$) et sa forte activité électromécanique. La forte permittivité diélectrique de ce polymère est due à une orientation dipolaire coopérative à l'intérieur de la phase cristalline du polymère qui conduit à un matériau ferroélectrique relaxeur.

Dans cette étude, le terpolymère P(VDF-TrFE-CFE) a été chimiquement modifié par l'utilisation de bis (2-éthylhexyle) (DEHP).

L'étude de ce terpolymère modifié montre une augmentation de la contrainte électrostrictive sous faible champ électrique appliqué d'un facteur 28 par rapport au terpolymère pur. L'étude de ce terpolymère modifié montre également que son énergie mécanique est augmentée d'un facteur 233 par rapport au terpolymère pur.

Cette modification chimique simple permet l'utilisation des propriétés naturelles du terpolymère à un champ électrique 5,5 fois plus faible que celle du terpolymère pur. En outre, le coût associé à la modification proposée (i.e. mélange du terpolymère pur avec un agent plastifiant) est faible.

Il a déjà été montré que dans le cas des polymères diélectriques, la contrainte électrostrictive sous champ électrique peut être principalement attribuée à des forces de Maxwell induites par l'orientation dipolaire à l'intérieur du matériau. Dans la direction longitudinale, la déformation de compression de Maxwell et la densité d'énergie mécanique sous champ électrique sont données par les équations (1) et (2) ci-dessous :

$$S_{33} = \frac{\varepsilon\varepsilon_0}{2Y}(1-2\nu)E^2 \qquad \text{(EQUATION 1)}$$

$$E_m = \frac{1}{2} Y S_{33}^2 \qquad \text{(EQUATION 2)}$$

Où:

- $S_{33}$ est la déformation longitudinale le long de la direction de l'épaisseur,
- $E_m$ est la densité de l'énergie mécanique,
- $\varepsilon$ est la constante diélectrique relative du matériau variable en fréquence et en champ électrique,
- $\varepsilon_0$ est la permittivité diélectrique du vide,
- v est le coefficient de Poisson du matériau,
- Y est le module de Young du matériau,
- E est le champ électrique appliqué au matériau.

On comprend à partir de l'équation (1) que la valeur des grands champs électriques habituellement nécessaire pour atteindre une déformation électrostrictives suffisante (quelques pourcents) peut être diminuée :

- en réduisant le module d'Young du polymère et / ou
- en augmentant la permittivité diélectrique du polymère.

Cependant, pour des applications d'actionneurs à faible fréquence, la densité d'énergie mécanique doit également être renforcée.

Ainsi, l'augmentation de la contrainte de déformation doit être plus élevée que la diminution de l'élasticité (module d'Young) du matériau.

Les plastifiants sont des molécules chimiques diélectriques couramment utilisées sur les polymères pour leurs effets plastifiants.

Toutefois dans le cadre de la présente invention, le plastifiant est utilisé pour d'autres raisons. Notamment, la modification chimique du polymère avec un plastifiant conduit à une augmentation de la mobilité moléculaire dans le polymère modifié induisant une diminution du module d'Young.

Les polymères sont des systèmes hétérogènes par nature. D'un point de vue électrique, au-dessus de la température de transition vitreuse et sous champ électrique appliqué, l'augmentation de la mobilité moléculaire permet aux charges d'être piégées dans les limites des hétérogénéités au sein du polymère modifié.

Dans le cas de polymères semi-cristallins, les charges piégées aux frontières des phases amorphe/cristalline induisent des effets de induction électrique Maxwell Wagner Sillars importants. Ce type d'induction électrique est associé à une augmentation importante de la permittivité diélectrique à basse fréquence.

Ainsi, le contrôle de la molécule d'agent plastifiant et de la matrice de polymère (hétérogénéités de phase, module d'Young, et permittivité diélectrique) permet la génération de grands dipôles macroscopiques associés à des hétérogénéités de phase et permet de réduire le module d'Young du polymère modifié, mais également d'accroître sa permittivité diélectrique.

On augmente ainsi à la fois la contrainte électrostrictive et la densité d'énergie mécanique du matériau.

L'influence de la teneur en DEHP sur le module d'élasticité mécanique (figure 3) du terpolymère a été caractérisée par une déformation de traction en fonction de mesures de contrainte.

La modification chimique apportée au terpolymère de P(VDF-TrFE-CFE) augmente la déformation élastique du matériau et diminue la déformation à la rupture (courbe 1) par rapport au terpolymère pur (courbe 2). Ces résultats sont en accord avec une augmentation de la mobilité moléculaire dans le matériau. Le lecteur appréciera qu'il n'existe pas d'influence de la teneur en DEHP dans la déformation à la rupture du polymère.

Contrairement aux solutions proposées dans l'art antérieur pour modifier un polymère, le terpolymère modifié selon l'invention n'est pas affaibli par modification chimique.

Le module d'Young du terpolymère P (VDF-TrFE-CFE) est égal à 65 MPa. Lorsque la quantité de DEHP mélangé au terpolymère augmente, le module d'Young du terpolymère modifié diminue. Pour 15 % en masse de DEHP par rapport à la masse totale du terpolymère modifié, le module d'Young est égal à 20 MPa.

Le lecteur appréciera que le mélange du terpolymère P (VDF-TrFE-CFE) avec le DEHP modifie très peu les propriétés thermiques et structurelles du polymère, la température de fusion du polymère pur étant de 127°C alors que la température de fusion du polymère modifié est de 120°C.

Les propriétés diélectriques des terpolymère pur et modifié ont également été caractérisées par la mesure de l'induction électrique en fonction du champ électrique appliqué à une fréquence de 100 mHz (figure 4A).

Pour de faibles champs électriques, l'induction électrique du terpolymère modifié est grandement augmentée (courbe 3) par rapport à l'induction électrique du terpolymère pur (courbe 4), celle-ci passant de 10 mC / $m^2$ à E = 20V/$\mu$m pour le terpolymère pur à plus de 75 mC / $m^2$ pour le terpolymère modifié (mélangé à 15% en pourcentage massique de DEHP).

L'évolution de la permittivité diélectrique avec le champ électrique a été calculée en utilisant la méthode de Debye-Langevin (figure 4B). Jusqu'à un champ électrique de 20 V / $\mu$m, la permittivité diélectrique relative effective du terpolymère pur reste à peu près constante à $\varepsilon$eff = 50.

Une grande augmentation de la permittivité diélectrique à faible champ a été observée pour le terpolymère modifié (courbe 5) par rapport au terpolymère pur (courbe 6). Pour un champ électrique supérieur, la permittivité diélectrique du terpolymère modifié passe de $\varepsilon$eff=725 à $\varepsilon$eff=190 pour un champ électrique E = 20V/$\mu$m. Ainsi, même à fort champ électrique appliqué, la permittivité diélectrique du terpolymère modifié reste supérieure à la permittivité diélectrique du terpolymère pur.

En conséquence, introduire du DEHP dans la matrice polymère a tendance à favoriser les phénomènes d'interface causés par les charges piégées à l'interface entre les phases amorphes et cristallines. Ce phénomène d'interface conduit à de grands dipôles qui sont responsables de l'augmentation importante de la permittivité diélectrique du terpolymère modifié.

L'ajustement de la permittivité diélectrique avec le champ électrique peut être considéré comme une saturation précoce des effets de polarisation Maxwell Wagner Sillars.

Alors que la propriété diélectrique du terpolymère pur peut être décrite comme un système biphasique (phase amorphe dipolaire et phase cristalline dipolaire), chaque phase ayant un champ électrique de saturation supérieur à 50 V/$\mu$m, le terpolymère modifié peut être considéré comme un système triphasique (effets interfaciaux dipolaires, phase amorphe dipolaire et phase cristalline dipolaire) avec un champ électrique de saturation de l'effet dipolaire interfacial beaucoup plus faible que celui du terpolymère pur, qui conduit malgré tout à des performances supérieures du terpolymère modifié.

L'influence du DEHP sur la réponse électrostrictive du terpolymère a été caractérisée par la déformation longitudinale sous champ électrique (figure 5). Les données expérimentales ont été comparées aux déformations de compression provoquées par les contraintes de Maxwell calculées à partir du module d'Young et des permittivités diélectriques ajustables mesurées précédemment.

Dans les deux cas, les contraintes de Maxwell sont bien représentatives du comportement électrostrictif des polymères pur et modifié (courbes 7 et 8). Pour un champ électrique allant de 0 à 13 V / $\mu$m :

- la déformation longitudinale du terpolymère pur a une dépendance quadratique avec le champ électrique, alors que
- la déformation longitudinale du terpolymère modifié ne présente pas de dépendance quadratique avec le champ électrique à cause de la saturation des phénomènes interfaciaux.

Pour un champ électrique de 10 V/$\mu$m, la déformation longitudinale est augmentée d'un facteur 28 (de 0,07% pour le terpolymère pur à 2% pour le terpolymère modifié avec 15% en masse de DEHP). A titre de comparaison, le champ électrique nécessaire pour atteindre une déformation de 2% avec le terpolymère pur est de 55 V/$\mu$m.

Outre l'augmentation de la réponse en déformation électrostrictive du polymère, une augmentation de la densité de l'énergie mécanique du polymère doit également être obtenue pour pouvoir utiliser celui-ci dans des dispositifs électro-actifs.

La modification proposée permet une amélioration de la densité de l'énergie mécanique de la matière active. Les densités d'énergie mécaniques Em des terpolymères pur et modifié ont été calculées à partir de l'équation (2) (figure 6).

A un faible champ électrique E = 11 V/$\mu$m, la densité d'énergie mécanique du terpolymère modifié (courbe 8) est 215 fois plus élevée celle du terpolymère pur (courbe 9). A ce champ électrique, la densité de l'énergie mécanique du terpolymère modifié (15%DEHP) atteint 5000 J/$m^3$, tandis qu'elle est seulement de 23 J/m3 pour le terpolymère pur.

Dans les applications pratiques, le DEHP permet une réduction significative (de 5,5 fois) du champ électrique. En conséquence, l'utilisation du DEHP ou de tout autre plastifiant à base de phtalates est une solution réaliste permettant de profiter des propriétés physiques du terpolymère à des champs électrique beaucoup plus faibles qu'avec le terpolymère pur.

Le lecteur aura compris que de nombreuses modifications peuvent être apportées au matériau composite et au procédé de fabrication décrits précédemment sans sortir matériellement des nouveaux enseignements et des avantages décrits ici.

Par exemple, dans les exemples précédents, le matériau plastifiant était le DEHP. D'autres types de plastifiants pourraient être utilisés comme par exemple :

- le phtalate de diisononyle (ou « *DINP »,* en anglais « *diisononyl phthalate »),* ou
- le phtalate de di-2 propyl heptyl (ou « *DPHP »,* en anglais « *di-2 propyl heptyl phthalate* »), ou
- phthalate de diisodécyl (ou « *DIDP »,* en anglais « *diisodecyl phthalate »),* ou
- tout autre plastifiant de la famille des phtalates connu de l'homme du métier.

Par conséquent, toutes les modifications de ce type sont destinées à être incorporées à l'intérieur de la portée des revendications jointes.

## Revendications

**1.** Matériau composite (13), **caractérisé en ce qu'**il comprend :

- au moins un polymère organique ferroélectrique relaxeur, le polymère organique ferroélectrique relaxeur étant un terpolymère à base de :
  - ◦ difluorure de vinylidène (VDF), de
  - ◦ trifluoroéthylène (TrFE), et de
  - ◦ chlorofluoro 1, 1 éthylène (CFE) ou de chlorotrifluoroéthylène (CTFE), et
- au moins un matériau plastifiant à base de phtalates.

**2.** Matériau composite (13) selon la revendication 1, dans lequel le polymère organique ferroélectrique relaxeur est un polymère de permittivité relative supérieure à 40 pour une fréquence de 100 mHz et une température de 25°C.

**3.** Matériau composite (13) selon l'une quelconque des revendications 1 ou 2, dans lequel le matériau plastifiant à base de phtalates est le Phtalate de bis(2-éthylhexyle) (DEHP).

**4.** Matériau composite (13) selon l'une quelconque des revendications 1 à 3, dans lequel :

- le matériau plastifiant à base de phtalates représente de 5 à 30 % en masse par rapport à la masse totale du matériau composite, et
- le polymère organique ferroélectrique relaxeur représente de 70 à 95 % en masse par rapport à la masse totale du matériau composite.

**5.** Matériau composite (13) selon l'une quelconque des revendications 1 à 4, lequel possède un état d'induction électrique d'au moins 50 mC/$m^2$ sous un champ électrique de 20V/$\mu$m.

**6.** Procédé de fabrication d'un matériau composite (13), **caractérisé en ce qu'**il comprend :

- une étape de mélange (10) d'au moins un polymère organique ferroélectrique relaxeur et d'au moins un matériau plastifiant à base de phtalates pour obtenir un mélange, le polymère organique ferroélectrique relaxeur étant un terpolymère à base de :

  ◦ difluorure de vinylidène (VDF), de
  ◦ trifluoroéthylène (TrFE), et de
  ◦ chlorofluoro 1, 1 éthylène (CFE) ou de chlorotrifluoroéthylène (CTFE), et

- une étape de traitement (20) du mélange pour obtenir le matériau composite, ladite étape de traitement incluant une sous-étape consistant à réaliser un film à partir du mélange et une sous-étape consistant à sécher et recuire ledit film.

**7.** Procédé de fabrication selon la revendication 6, dans lequel l'étape de mélange (10) est réalisée par voie solvant et comprend les sous-étapes consistant à :

- solubiliser le polymère organique ferroélectrique relaxeur plastifiant et le matériau plastifiant à base de phtalates dans au moins un solvant commun au polymère organique ferroélectrique relaxeur plastifiant et au matériau plastifiant à base de phtalates,
- éliminer ledit et au moins un solvant.

**8.** Procédé de fabrication selon la revendication 6, dans lequel l'étape de mélange (10) est réalisée par voie fondue.

**9.** Procédé de fabrication selon l'une quelconque des revendications 6 à 8, dans lequel la sous-étape de recuit consiste en un chauffage :

- à une température inférieure à la température de fusion du mélange, et
- pendant une durée supérieure ou égale à une minute.

**10.** Procédé de fabrication selon l'une quelconque des revendications 6 à 9, lequel comprend en outre une étape consistant au dépôt d'électrodes (30) sur le matériau composite (13).

**11.** Elément actionneur **caractérisé en ce qu'**il comprend une pièce incluant le matériau composite selon l'une quelconque des revendications 1 à 5, et au moins deux électrodes liées à ladite pièce et mutuellement isolées, lequel élément actionneur pouvant être incurvé et déformé par application d'une différence de potentiel électrique entre les deux électrodes.

## Patentansprüche

**1.** Verbundwerkstoff (13), **dadurch gekennzeichnet, dass** er Folgendes umfasst:

- mindestens ein relaxierendes ferroelektrisches organisches Polymer, wobei das relaxierende ferroelektrische organische Polymer ein Terpolymer auf Basis von Folgendem ist:

  ◦ Vinylidendifluorid (VDF), von
  ◦ Trifluorethylen (TrFE) und von
  ◦ 1,1-Chlorfluorethylen (CFE) oder Chlortrifluorethylen (CTFE) und

- mindestens einen Weichmacher auf Phthalatbasis.

**2.** Verbundwerkstoff (13) nach Anspruch 1, wobei das relaxierende ferroelektrische organische Polymer ein Polymer mit relativer Permitivität von höher als 40 bei einer Frequenz von 100 mHz und einer Temperatur von 25°C ist.

**3.** Verbundwerkstoff (13) nach einem der Ansprüche 1 oder 2, wobei der Weichmacher auf Phthalatbasis Bis (2-ethylhexyl)phthalat (DEHP) ist.

**4.** Verbundwerkstoff (13) nach einem der Ansprüche 1 bis 3, wobei:

- der Weichmacher auf Phthalatbasis zwischen 5 und 30 Ma% im Verhältnis zur Gesamtmasse des Verbundwerkstoffs darstellt, und
- das relaxierende ferroelektrische organische Polymer zwischen 70 und 95 Ma% im Verhältnis zur Gesamtmasse des Verbundwerkstoffs darstellt.

**5.** Verbundwerkstoff (13) nach einem der Ansprüche 1 bis 4, das unter einem elektrischen Feld von 20V/µm einen elektrischen Induktionszustand von mindestens 50 mC/$m^2$ besitzt.

**6.** Verfahren zur Herstellung eines Verbundwerkstoffs (13), **dadurch gekennzeichnet, dass** es Folgendes umfasst:

- einen Schritt zum Mischen (10) von mindestens einem relaxierenden ferroelektrischen organischen Polymer und mindestens einem Weichmacher auf Phthalatbasis zum Erhalten einer Mischung, wobei das relaxierende ferroelektrische organische Polymer ein Terpolymer auf Basis von Folgendem ist:

  ◦ Vinylidendifluorid (VDF), von
  ◦ Trifluorethylen (TrFE) und von
  ◦ 1,1-Chlorfluorethylen (CFE) oder Chlortrifluorethylen (CTFE) und

- einen Schritt zur Behandlung (20) der Mischung zum Erhalten des Verbundwerkstoffs, wobei der Behandlungsschritt einen Teilschritt, der darin besteht, eine dünne Schicht ausgehend von der Mischung auszuführen, und einen Teilschritt umfasst, der darin besteht, die dünne Schicht trocknen und glühen zu lassen.

**7.** Herstellungsverfahren nach Anspruch 6, wobei der Schritt zum Mischen (10) unter Verwendung eines Lösungsmittels ausgeführt wird und die Teilschritte umfasst, die aus Folgendem bestehen:

- Löslichmachen des weichmachenden relaxierenden ferroelektrischen organischen Polymers und des Weichmachers auf Phthalatbasis in mindestens einem Lösungsmittel, das dem weichmachenden relaxierenden ferroelektrischen organischen Polymer und dem Weichmacher auf Phthalatbasis gemein ist,
- Beseitigen des mindestens einen Lösungsmittels.

**8.** Herstellungsverfahren nach Anspruch 6, wobei der Schritt zum Mischen (10) durch Schmelzen ausgeführt wird.

**9.** Herstellungsverfahren nach einem der Anspruche 6 bis 8, wobei der Unterschritt zum Glühen aus einem Erhitzen wie folgt besteht:

- auf eine Temperatur, die niedriger als die Schmelztemperatur der Mischung ist, und
- während einer Dauer von länger oder gleich einer Minute.

**10.** Herstellungsverfahren nach einem der Ansprüche 6 bis 9, das ferner einen Schritt umfasst, der aus dem Aufbringen von Elektroden (30) auf dem Verbundwerkstoff (13) besteht.

**11.** Betätigungselement, **dadurch gekennzeichnet, dass** es ein Teil umfasst, das den Verbundwerkstoff nach einem der Ansprüche 1 bis 5 und mindestens zwei Elektroden umfasst, die mit dem Teil verbunden und gegenseitig isoliert sind, wobei das Betätigungselement gekrümmt und durch Anlegen von einer elektrischen Potentialdifferenz zwischen den zwei Elektroden verformt werden kann.

## Claims

**1.** A composite material (13), **characterized in that** it comprises:

- at least one ferroelectric organic polymer with relaxation properties, wherein the ferroelectric organic polymer with relaxation properties is a terpolymer based on:

  ◦ vinylidene difluoride (VDF),
  ◦ trifluoroethylene (TrFE), and
  ◦ chlorofluoro-1,1-ethylene (CFE) or chlorotrifluoroethylene (CTFE), and

- at least one phthalate-based plasticizer material.

2. The composite material (13) according to claim 1, wherein the ferroelectric organic polymer with relaxation properties is a polymer with relative permittivity above 40 for a frequency of 100 mHz and a temperature of 25° C.

3. The composite material (13) according to any one of claims 1 or 2, wherein the phthalate-based plasticizer material is bis(2-ethylhexyl) phthalate (DEHP).

4. The composite material (13) according to any one of claims 1 to 3, wherein:

- the phthalate-based plasticizer material represents from 5 to 30 wt % relative to the total weight of the composite material, and
- the ferroelectric organic polymer with relaxation properties represents from 70 to 95 wt % relative to the total weight of the composite material.

5. The composite material (13) according to any one of claims 1 to 4, which has a state of electrical induction of at least 50 $mC/m^2$ under an electric field of 20 V/$\mu$m.

6. A method for manufacturing a composite material (13), **characterized in that** it comprises:

- a step of mixing (10) at least one ferroelectric organic polymer with relaxation properties and at least one phthalate-based plasticizer material to obtain a mixture, wherein the ferroelectric organic polymer with relaxation properties is a terpolymer based on:

◦ vinylidene difluoride (VDF),
◦ trifluoroethylene (TrFE), and
◦ chlorofluoro-1,1-ethylene (CFE) or chlorotrifluoroethylene (CTFE), and

- a step of treating (20) the mixture to obtain the composite material, wherein said step of treating includes a substep consisting of producing a film from the mixture and a substep consisting of drying and annealing said film.

7. The method of manufacture according to claim 6, wherein the step of mixing (10) is carried out by the solvent route and comprises the substeps consisting in:

- dissolving the plasticizing ferroelectric organic polymer with relaxation properties and the phthalate-based plasticizer material in at least one solvent common to the plasticizing ferroelectric organic polymer with relaxation properties and to the phthalate-based plasticizer material,
- removing said at least one solvent.

8. The method of manufacture according to claim 6, wherein the step of mixing (10) is carried out by the melt route.

9. The method of manufacture according to any one of claims 6 to 8, wherein the substep of annealing consists of heating:

- to a temperature below the melting point of the mixture, and
- for a time greater than or equal to one minute.

10. The method of manufacture according to any one of claims 6 to 9, which further comprises a step of depositing electrodes (30) on the composite material (13).

11. An actuating element **characterized in that** it comprises a component including the composite material according to any one of claims 1 to 5, and at least two electrodes connected to said component and mutually insulated, which actuating element being curvable and deformable by application of a difference in electrical potential between the two electrodes.

FIG. 1

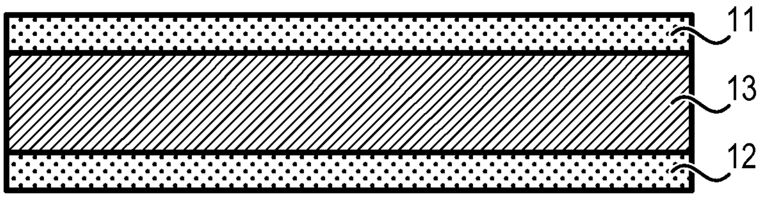


FIG. 2

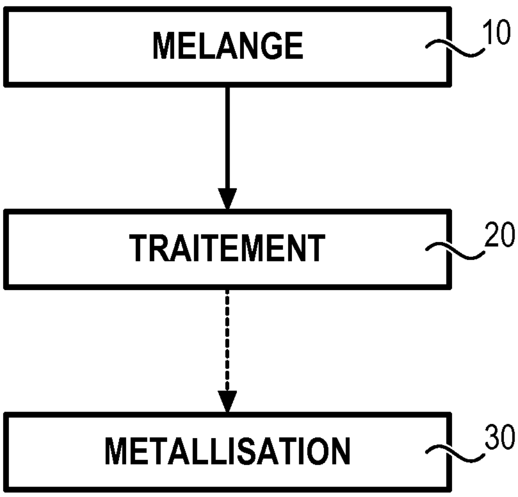

FIG. 3

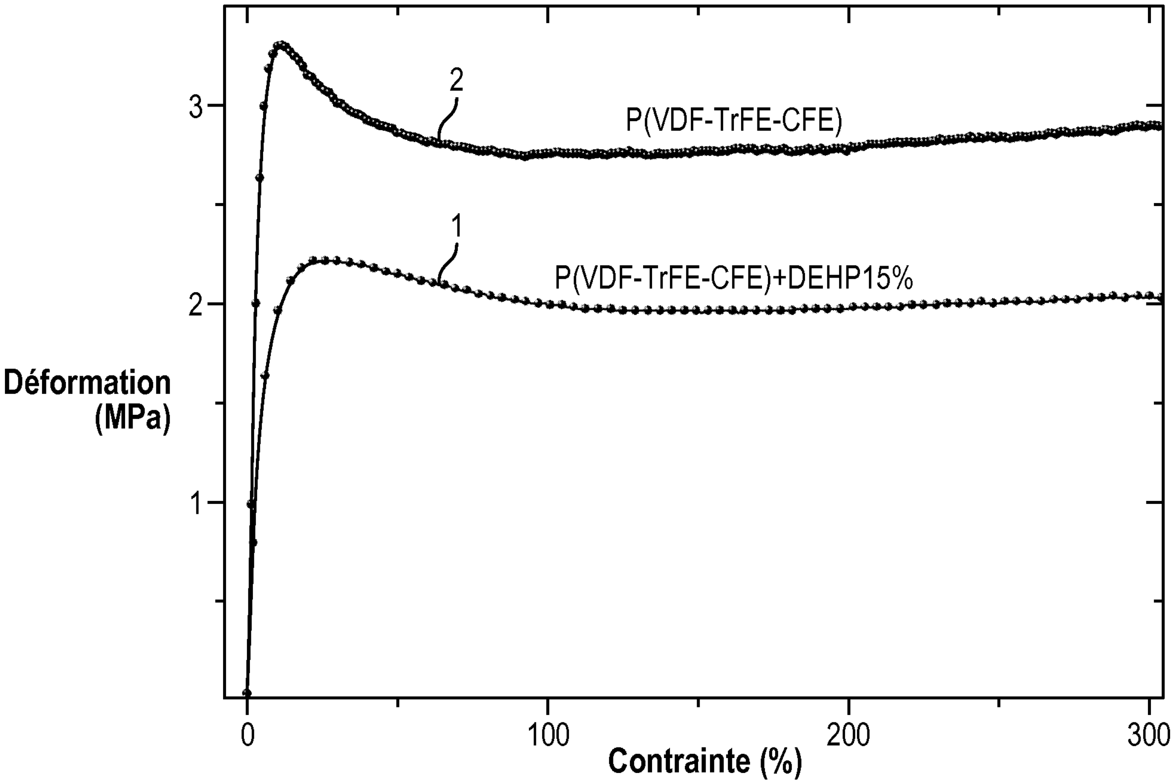
2
P(VDF-TrFE-CFE)
1
P(VDF-TrFE-CFE)+DEHP15%
Déformation (MPa)
3
2
1
0
100
200
300
Contrainte (%)

FIG. 4A

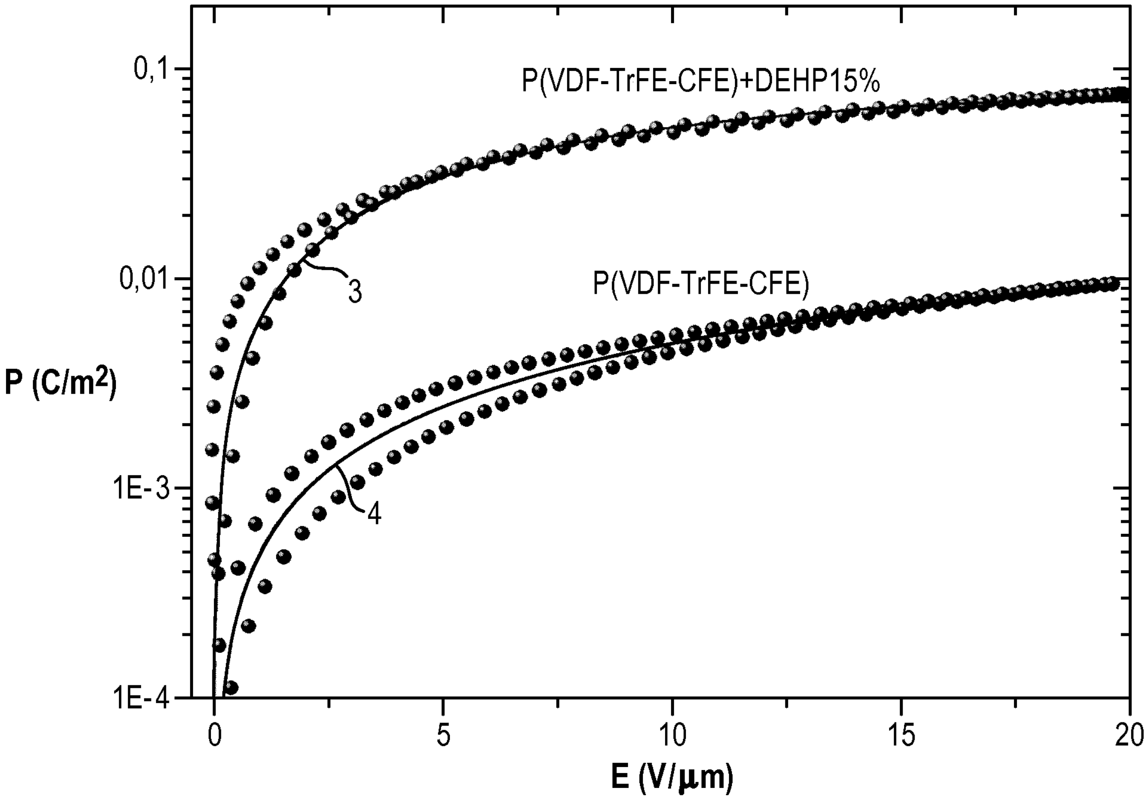
P(VDF-TrFE-CFE)+DEHP15%
P(VDF-TrFE-CFE)
3
4
P (C/m2)
0,1
0,01
1E-3
1E-4
0
5
10
15
20
E (V/µm)

FIG. 4B

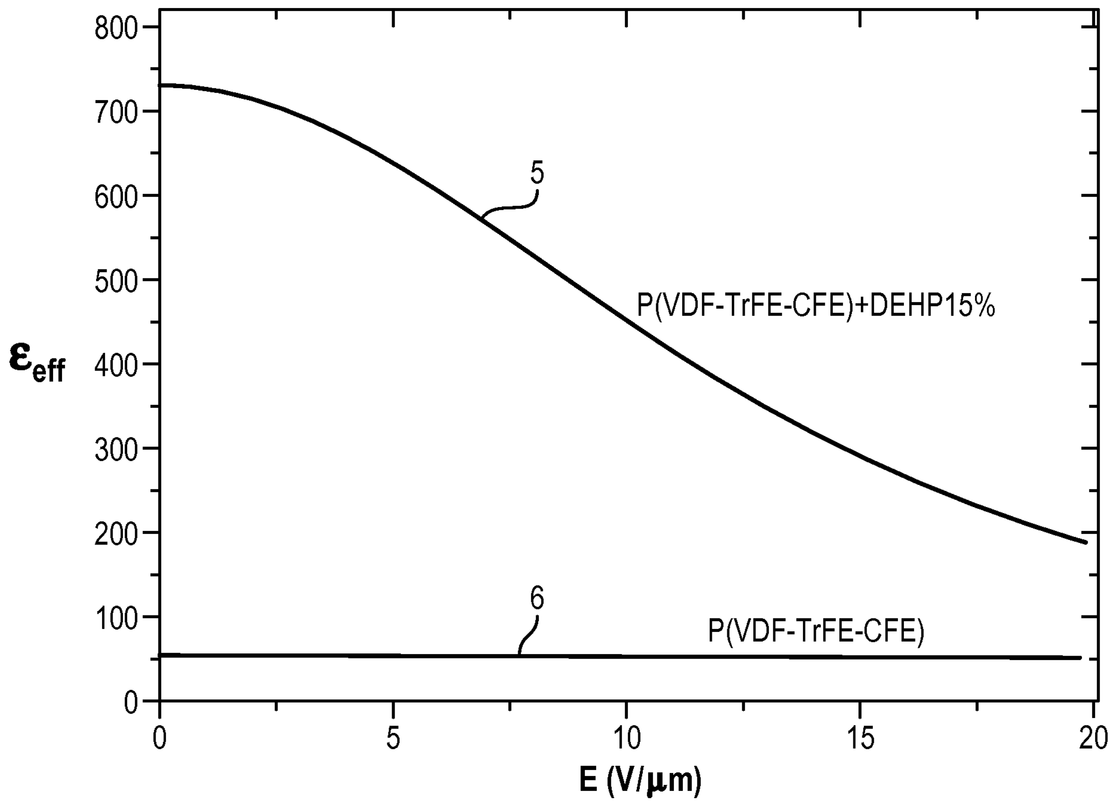
800
700
600
500
400
300
200
100
0
$\varepsilon_{eff}$
5
P(VDF-TrFE-CFE)+DEHP15%
6
P(VDF-TrFE-CFE)
0
5
10
15
20
E (V/µm)

FIG. 5

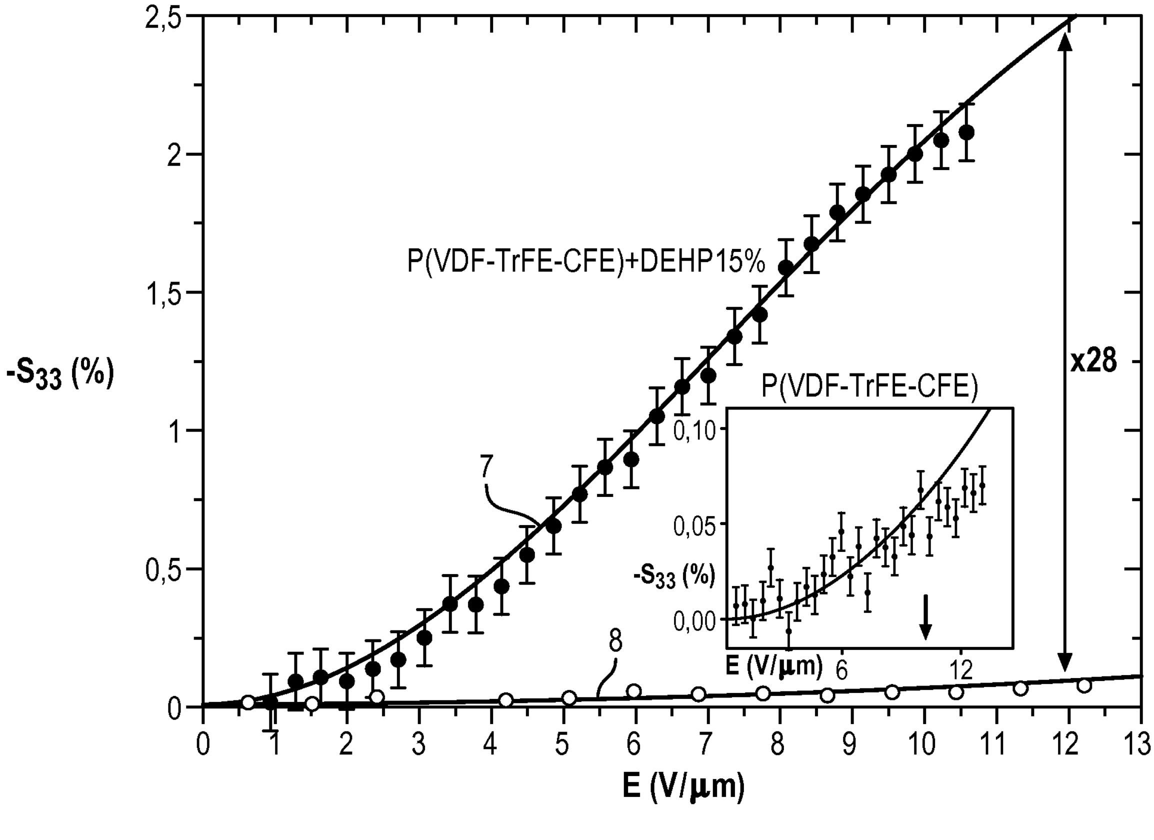
2,5
2
1,5
1
0,5
0
-S33 (%)
P(VDF-TrFE-CFE)+DEHP15%
7
8
x28
P(VDF-TrFE-CFE)
0,10
0,05
0,00
-S33 (%)
E (V/µm)
6
12
0
1
2
3
4
5
6
7
8
9
10
11
12
13
E (V/µm)

FIG. 6

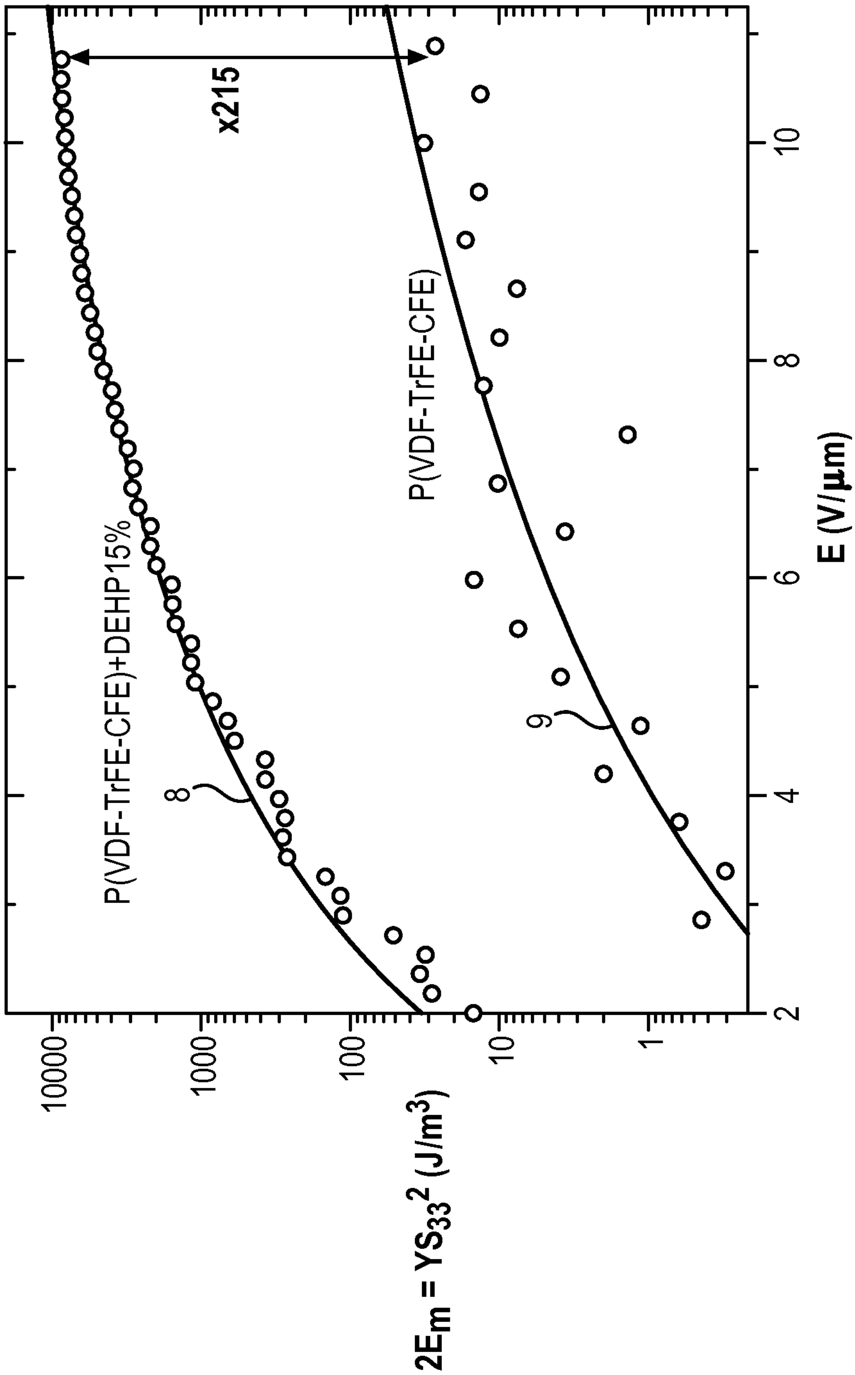
2Em = YS33² (J/m³)
10000
1000
100
10
1
E (V/µm)
2
4
6
8
10
P(VDF-TrFE-CFE)+DEHP15%
P(VDF-TrFE-CFE)
x215
8
9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 20100148632 A
- US 2010148632 A